# EUROPEAN PATENT APPLICATION

(11) **EP 2 482 329 A2**
(43) Date of publication of application: **01.08.2012**
(21) Application number: 12152900.2
(22) Date of filing: 27.01.2012
(51) Int. Cl.: H01L 31/0296, H01L 31/0224

(54) **Photovoltaic device**

(30) Priority: 01.02.2011 US 201113018650
(71) Applicant: General Electric Company, Schenectady, New York 12345 (US)
(72) Inventor: Korevaar, Bastiaan Arie, Niskayuna, NY 12309 (US); Bray, James William, Niskayuna, NY 12309 (US)
(74) Representative: Szary, Anne Catherine

(57) **Abstract**

A photovoltaic device includes a first semiconductor layer; a p+-type semiconductor layer; and an interlayer interposed between the first semiconductor layer and the p+-type semiconductor layer, wherein the interlayer includes magnesium and tellurium.

## Description

### BACKGROUND

The invention generally relates to photovoltaic devices. More particularly, the invention relates to improved back contacts for photovoltaic devices.

Thin film solar cells or photovoltaic devices typically include a plurality of semiconductor layers disposed on a transparent substrate, wherein one layer serves as a window layer and a second layer serves as an absorber layer. The window layer allows the penetration of solar radiation to the absorber layer, where the optical energy is converted to usable electrical energy. Cadmium telluride/cadmium sulfide (CdTe/CdS) heterojunction-based photovoltaic cells are one such example of thin films solar cells.

Cadmium telluride (CdTe)-based photovoltaic devices typically demonstrate relatively low power conversion efficiencies, which may be attributed to a relatively low open circuit voltage (*V*_{oc}) in relation to the band gap of the material which is due, in part, to the low effective carrier concentration and short minority carrier lifetime in CdTe. The short minority carrier lifetime that is typically exhibited by thin film CdTe devices may be attributed to the high defect density that occurs when thin film CdTe is grown at relatively low temperatures (500-550 °C) using close-spaced sublimation (or CSS). The high defect density results in the presence of donor and acceptor states that offset each other, resulting in an effective carrier density in the 10¹¹ to 10¹⁵ per cubic centimeter (cc) range for CdTe.

Further, there is an increased drive for decreasing the thickness of the CdTe layer because of the low availability of tellurium and also increased interest in photovoltaic devices with "n-i-p" configuration. However, thinner CdTe layer may lead to recombination of electron-hole pairs at the back contact and lower open circuit voltage. Thus, minimizing the recombination of the electron/hole pairs at the back contact layer in thin film CdTe photovoltaic cells may be desirable.

Further issues with improving the cell efficiency of CdTe solar cells include the high work function of CdTe. The high work function of CdTe allows a narrow choice of metals that can be employed to form an Ohmic back contact with the CdTe layer. One approach to improve the back-contact resistance includes increasing the carrier concentration in the regions near the contact points of the CdTe layer and the back contact layer, wherein the back contact layer is a metal layer. For example, for a p-type CdTe material, increasing the carrier concentration amounts to increasing the p-type carriers in the CdTe material to form a "p+ layer" on the backside of the CdTe layer, which is in contact with the back contact layer. However, typical methods employed to form the p+ layers may pose drawbacks such as, for example, diffusion of metal through CdTe causing degradation and environmental concerns.

Thus, there is a need to provide improved back contact layer configuration to provide improved interfaces and to minimize recombination of electron/hole pairs at the back contact. Further, there is a need to provide cost-effective photovoltaic devices having improved back contact to provide the desired power conversion efficiencies.

### BRIEF DESCRIPTION OF THE INVENTION

Embodiments of the present invention are provided to meet these and other needs. One embodiment is a photovoltaic device. The photovoltaic device includes a first semiconductor layer; a p+-type semiconductor layer; and an interlayer interposed between the first semiconductor layer and the p+-type semiconductor layer, wherein the interlayer includes magnesium and tellurium.

Another embodiment is a photovoltaic device. The photovoltaic device includes a support and a second electrically conductive layer disposed on the support. The photovoltaic device further includes an n-type semiconductor layer disposed on the second electrically conductive layer and a substantially intrinsic semiconductor layer disposed on the n-type semiconductor layer. The photovoltaic device further includes a p+-type semiconductor layer disposed on the substantially intrinsic semiconductor layer and a first electrically conductive layer disposed on the p+-type semiconductor layer. An interlayer is interposed between the p+-type semiconductor layer and the substantially intrinsic semiconductor layer, wherein the interlayer includes magnesium and tellurium.

### DRAWINGS

These and other features, aspects, and advantages of the present invention will become better understood when the following detailed description is read with reference to the accompanying drawings, wherein:
FIG. 1 is a schematic of a photovoltaic device, according to an exemplary embodiment of the invention.
FIG. 2 is a schematic of a photovoltaic device, according to an exemplary embodiment of the invention.
FIG. 3 is a schematic of a photovoltaic device, according to an exemplary embodiment of the invention.

### DETAILED DESCRIPTION

As discussed in detail below, some of the embodiments of the invention provide improved back contacts for photovoltaic devices. In one embodiment, the improved back contact includes an absorber layer, a p+-type semiconductor layer, and an interlayer interposed between the absorber layer and the p+-type semiconductor layer. In some embodiments, the interlayer may provide an interface having low concentration of defect states between the absorber layer and the p+-type semiconductor layer. In certain embodiments, the interlayer includes magnesium and tellurium and has a lattice constant that substantially matches the lattice constant of the absorber layer material, thus forming an improved interface. The lattice matching of the interlayer and the absorber layer may be particularly desirable for thin film CdTe devices, such as, for example, photovoltaic devices having "n-i-p" configuration, as it reduces strain in the two layers and thereby reduces defects.

In one embodiment, the interlayer is p-doped such that the interlayer advantageously functions as a separation layer between the holes and the electrons and thus minimizes recombination of electron/hole pairs at the back contact. In some embodiments, the interlayer may function as an electron reflector into the absorber layer, especially if the mismatch in energy gap of the interlayer and the absorber layer is such that the conduction band level of the interlayer is significantly above that of the absorber layer. In some embodiments, a combination of the p-type interlayer and the absorber layer may provide for an improved back contact having minimal electron/hole pair recombination in thin film CdTe photovoltaic devices having "n-i-p" configuration.

Approximating language, as used herein throughout the specification and claims, may be applied to modify any quantitative representation that could permissibly vary without resulting in a change in the basic function to which it is related. Accordingly, a value modified by a term or terms, such as "about", is not limited to the precise value specified. In some instances, the approximating language may correspond to the precision of an instrument for measuring the value.

In the following specification and the claims, the singular forms "a", "an" and "the" include plural referents unless the context clearly dictates otherwise.

As used herein, the terms "may" and "may be" indicate a possibility of an occurrence within a set of circumstances; a possession of a specified property, characteristic or function; and/or qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances, an event or capacity can be expected, while in other circumstances the event or capacity cannot occur - this distinction is captured by the terms "may" and "may be".

The terms "transparent region", "transparent layer" and "transparent electrode" as used herein, refer to a region, a layer, or an article that allows an average transmission of at least 80% of incident electromagnetic radiation having a wavelength in a range from about 300 nm to about 850 nm. As used herein, the term "disposed on" refers to layers disposed directly in contact with each other or indirectly by having intervening layers therebetween.

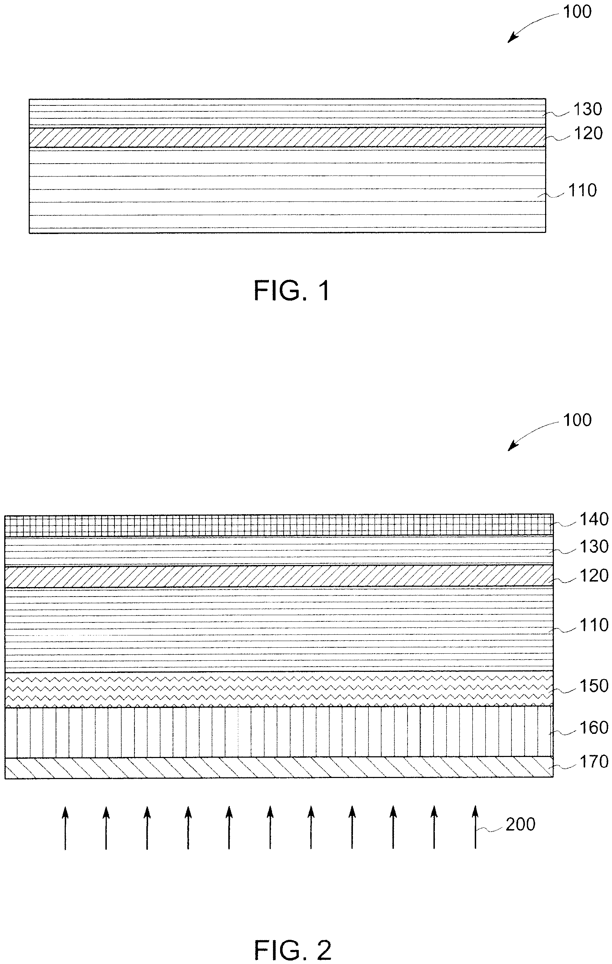

As discussed in detail below, some embodiments of the invention are directed to an improved back contact for a photovoltaic device. A photovoltaic device 100 according to one embodiment of the invention is illustrated in Figures 1-3. As shown in Figures 1-3, the photovoltaic device 100 includes a first semiconductor layer 110 and a p+-type semiconductor layer 130 disposed on the first semiconductor layer 110. The photovoltaic device 100 further includes an interlayer 120 interposed between the first semiconductor layer 110 and the p+-type semiconductor layer 130, wherein the interlayer 120 includes magnesium and tellurium. In one embodiment, the photovoltaic device 100 further includes a first electrically conductive layer 140 disposed on the p+-type semiconductor layer 130, as indicated in Fig. 2. In some embodiments, a combination of the interlayer 120, the p+-type semiconductor layer 130, and the first electrically conductive layer 140 may provide for an improved back contact in the photovoltaic device 100.

As indicated in Fig. 2, in one embodiment, the photovoltaic device 100 further includes a second semiconductor layer 150, wherein the first semiconductor layer 140 is disposed on the second semiconductor layer 150. In one embodiment, the photovoltaic device 100 further includes a second electrically conductive layer 160 and a support 170, wherein the second electrically conductive layer 160 is disposed on the support 170 and the second semiconductor layer 150 is disposed on the second electrically conductive layer 160 to form the photovoltaic device 100. As illustrated in Fig. 2, in such embodiments, the solar radiation 200 enters from the support 100 and, after passing through the second electrically conductive layer 160 and the second semiconductor layer 150, enters the first semiconducting layer 110, where the conversion of electromagnetic energy of incident light (for instance, sunlight) to electron-hole pairs (that is, to free electrical charge) occurs.

In some embodiments, the first semiconductor layer 110 and the second semiconductor layer 150 may be doped with a p-type dopant or n-type dopant to form a heterojunction. As used in this context, a heterojunction is a semiconductor junction that is composed of layers of dissimilar semiconductor materials. These materials usually have non-equal band gaps. As an example, a heterojunction can be formed by contact between a layer or region of one conductivity type with a layer or region of opposite conductivity, e.g., a "p-n" junction.

In some embodiments, the first semiconductor layer 110 includes an absorber layer. Typically, when solar radiation is incident on the photovoltaic device 100, electrons in the absorber layer 110 are excited from a lower energy "ground state," in which they are bound to specific atoms in the solid, to a higher "excited state," in which they can move through the solid. Since most of the energy in sunlight and artificial light is in the visible range of electromagnetic radiation, a solar cell absorber should be efficient in absorbing radiation at those wavelengths.

In one embodiment, the first semiconductor layer 110 includes a p-type semiconductor material. In one embodiment, the first semiconductor layer 110 has a carrier density in a range from about 1 x 10¹³ per cubic centimeter (cc) to about 1 x 10¹⁵ per cubic centimeter (cc). As used herein, the term "carrier density" refers to the concentration of holes and electrons in a material. In such instances, the second semiconducting layer 150 may be doped to be n-type and the first semiconductor layer 110 and the second semiconductor layer 150 may form a "p-n" or "n-p" junction as mentioned above.

In one embodiment, a photoactive material is used for forming the first semiconducting layer 110. Suitable photo-active materials include cadmium telluride (CdTe), cadmium zinc telluride (CdZnTe), cadmium magnesium telluride (CdMgTe), cadmium manganese telluride (CdMnTe), cadmium sulfur telluride (CdSTe), zinc telluride (ZnTe), CIS (copper, indium, sulphur), CIGS (copper, indium, gallium, selenium), and combinations thereof. The above-mentioned photo-active semiconductor materials may be used alone or in combination. Further, these materials may be present in more than one layer, each layer having different type of photo-active material or having combinations of the materials in separate layers. In one particular embodiment, the first semiconductor layer 110 includes cadmium telluride (CdTe). In one particular embodiment, the first semiconductor layer 110 includes p-type cadmium telluride (CdTe).

In another embodiment, the first semiconductor layer 110 includes a substantially intrinsic semiconductor material (i-type). As used herein, the term "substantially intrinsic" refers to a semiconductor material having a carrier density of less than about 10¹³ per cubic centimeter (cc). As will be recognized by those skilled in the art, carrier concentrations in this range may be achieved for both actively doped material and material formed without the active introduction of dopants. In some embodiments, the second semiconducting layer 150 may be doped to be n-type, and the first semiconductor layer 110, the second semiconductor layer 150, and the interlayer 120 may form a "p-i-n" or "n-i-p" junction.

As known in the art, carrier pairs generated in the substantially intrinsic semiconductor layer are separated by an internal field generated by the respective doped layers, so as to create the photovoltaic current. In this manner, the n-i-p structure, when exposed to appropriate illumination, generates a photovoltaic current, which is collected by the electrically conductive layers 140 and 170, which are in electrical communication with appropriate layers of the device.

In one embodiment, the substantially intrinsic material includes cadmium and tellurium. In one embodiment, the first semiconductor layer 110 includes a substantially intrinsic material selected from a group consisting of cadmium telluride, cadmium zinc telluride, cadmium sulfur telluride, cadmium manganese telluride, cadmium magnesium telluride, and combinations thereof. In one embodiment, the first semiconductor layer 110 has a band gap in a range from about 1.3 electron Volts to about 1.6 electron Volts. In another embodiment, the first semiconductor layer 110 has a band gap in a range from about 1.35 electron Volts to about 1.55 electron Volts. In yet another embodiment, the first semiconductor layer 110 has a band gap in a range from about 1.4 electron Volts to about 1.5 electron Volts. In one embodiment, the first semiconductor layer 110 is selected such that the band gap of the p+-type semiconductor layer 130 may be greater than or equal to the band gap of the first semiconductor layer 110. In one embodiment, the first semiconductor layer 110 is selected such that the band gap of the interlayer 120 may be greater than or equal to the band gap of the first semiconductor layer 110.

In one embodiment, the first semiconductor layer has a thickness in a range from about 1000 nm to about 3000 nm. In a particular embodiment, the first semiconductor layer has a thickness in a range from about 1500 nm to about 2000 nm. As noted earlier, the use of the interlayer 120 according to some embodiments of the invention advantageously provides for an improved interface at the back-side of the CdTe-layer, reducing the recombination rate at that interface, providing a low recombining back contact for photovoltaic devices employing thin CdTe layers, such as, for example having a thickness in a range less than about 2 microns. Accordingly, in some embodiments, the interlayer may advantageously allow for thinner CdTe layers to be employed in photovoltaic devices.

The term "p+-type semiconductor layer" as used herein refers to a semiconductor layer having an excess mobile p-type carrier or hole density compared to the p-type charge carrier or hole density in the first semiconductor layer 110. In one embodiment, the p+-type semiconductor layer has a p-type carrier density in a range greater than about 1 x 10¹⁷ per cubic centimeter (cc). In another embodiment, the p+-type semiconductor layer has a p-type carrier density in a range greater than about 5 x 10¹⁷ per cubic centimeter (cc). In yet another embodiment, the p+-type semiconductor layer has a p-type carrier density in a range greater than about 10¹⁸ per cubic centimeter (cc). In a particular embodiment, the p+-type semiconductor layer has a p-type carrier density in a range from about 10¹⁷ per cubic centimeter (cc) to about 10²⁰ per cubic centimeter (cc). The p+-type semiconductor layer 130 may be used as an interface between the first semiconductor layer 110 and the first electrically conductive layer or the back contact layer 140 in some embodiments. Higher carrier densities of the p+-type semiconductor layer 130 may minimize the series resistance of the back contact layer, in comparison to other resistances within the device. In one embodiment, the p+-type semiconductor layer has a thickness in a range from about 50 nm to about 200 nm.

In one embodiment, the p+-type semiconductor layer 130 has a band gap in a range from about 1.5 electron Volts to about 3.5 electron Volts. In another embodiment, the p+-type semiconductor layer 130 has a band gap in a range from about 1.5 electron Volts to about 2.0 electron Volts. In yet another embodiment, the p+-type semiconductor layer 130 has a band gap in a range from about 1.8 electron Volts to about 1.9 electron Volts. In yet another embodiment, the p+-type semiconductor layer 130 has a band gap in a range from about 2.5 electron Volts to about 3.5 electron Volts. As mentioned above, in one embodiment, the p+-type semiconductor layer 130 is selected such that the band gap of the p+-type semiconductor layer 130 may be greater than or equal to the band gap of the first semiconductor layer 110.

In one embodiment, the p+-type semiconductor layer 130 includes a doped p-type material selected from a group consisting of amorphous Si: H, amorphous SiC: H, crystalline Si, microcrystalline Si: H, microcrystalline SiGe: H, amorphous SiGe: H, amorphous Ge, microcrystalline Ge, GaAs, BaCuSF, BaCuSeF, BaCuTeF, LaCuOS, LaCuOSe, LaCuOTe, (LaSr)CuOS, LaCuOSe_{0.6}Te_{0.4}, BiCuOSe, (BiCa)CuOSe, PrCuOSe, NdCuOS, Sr₂Cu₂ZnO₂S₂, Sr₂CuGaO₃S, and combinations thereof.

In another embodiment, the p+-type semiconductor layer 130 includes a doped p+-doped material selected from a group consisting of zinc telluride, magnesium telluride, manganese telluride, beryllium telluride, mercury telluride, arsenic telluride, antimony telluride, copper telluride, and combinations thereof. In some embodiments, the p+-doped material further includes a dopant selected from a group consisting of copper, gold, nitrogen, phosphorus, antimony, arsenic, silver, bismuth, sulfur, sodium, and combinations thereof.

As noted earlier, the photovoltaic device 100 further includes an interlayer interposed between the first semiconductor layer 110 and the p+-type semiconductor layer 130, wherein the interlayer 120 includes magnesium and tellurium. In one embodiment, the interlayer includes a composition having a formula (I):

MgₓCd₁₋ₓTe

wherein "x" is in a range from about 0.05 to about 0.6. In another embodiment, "x" is in a range from about 0.1 to about 0.5. In yet another embodiment, "x" is in a range from about 0.1 to about 0.3. In some embodiments, the interlayer 110 may further include one or more suitable dopants. In some embodiments, the interlayer may include a graded magnesium concentration, that is, the concentration of magnesium may vary across the thickness of the interlayer. In some embodiments, the concentration of the dopant may be selected such that the interlayer has a higher band gap than the first semiconductor layer and functions as an electron reflector layer.

In some embodiments, the composition of the interlayer 120 may be selected to advantageously match the lattice constants of the interlayer and the first semiconductor layer 110. In one embodiment, the composition of the interlayer 120 may be selected to advantageously match the lattice constants of the interlayer and the CdTe in the first semiconducting layer 110. In one embodiment, a percentage difference between a lattice constant of the first semiconductor layer 110 and a lattice constant of the interlayer 120 is less than about 1%. In another embodiment, a percentage difference between a lattice constant of the first semiconductor layer 110 and a lattice constant of the interlayer 120 is less than about 0.1%. In yet another embodiment, a lattice constant of the first semiconductor layer 110 and a lattice constant of the interlayer 120 is substantially the same. Without being bound by any theory, it is believed that improved lattice matching between the two layers may result in reduced interfacial defects between the layers, which may be desirable to increase the carrier lifetimes.

In some embodiments, the interlayer 120 includes magnesium telluride (MgTe). For embodiments employing CdTe as the first semiconducting layer 110, MgTe as the interlayer 120 may advantageously provide for an improved interface having minimal defects because the lattice constant of MgTe is well-matched to the lattice constant of CdTe (that is, their crystal structure and lattice constant are substantially similar). In some other embodiments, the interlayer 120 includes ternary magnesium cadmium telluride, which may further reduce strain at the interlayer 120 and the first semiconductor layer 110 interface.

In one embodiment, the interlayer includes a p-type material or an intrinsic material. In a particular embodiment, the interlayer 120 includes a lightly doped p-type material. In one embodiment, the band gap offset between the first semiconductor layer and the interlayer may result in charge separation and thus minimize recombination of electron/hole pairs at the back contact. In one embodiment, the interlayer 120 may function as an electron reflector into the first semiconductor layer 110. In some embodiments, the combination of the lightly doped p-type interlayer 110 and the p+-type semiconductor layer 130 may result in depletion of the interlayer 110, and create a field into the first semiconductor layer 110. In some embodiments, a combination of the lightly doped p-type interlayer 120 and the p+-type semiconducting layer may provide for an improved back contact having minimal electron/hole pair recombination. In one embodiment, the interlayer 120 includes a p-doped magnesium telluride or a p-doped magnesium cadmium telluride.

In some embodiments, to avoid formation of a potential barrier at the interlayer 120 and first semiconductor layer 110 interface, the composition of interlayer 120 may be selected to avoid a bandgap discontinuity between interlayer 120 and first semiconductor layer 110. In one embodiment, the composition of the interlayer 120 may be further selected such that the band gap of the interlayer 120 is greater than or equal to the band gap of the first semiconductor layer 110. In one embodiment, the interlayer 120 has a band gap in a range from about 1.6 eV to about 3.5 eV. In another embodiment, the interlayer 120 has a band gap in a range from about 1.8 eV to about 3 eV. In yet another embodiment, the interlayer 120 has a band gap in a range from about 2 eV to about 3 eV. In a particular embodiment, the interlayer 120 has a band gap in a range from about 1.6 eV to about 2.5 eV. In one embodiment, the interlayer 120 has a thickness in a range from about 10 nm to about 100 nm. In another embodiment, the interlayer 120 has a thickness in a range from about 10 nm to about 50 nm.

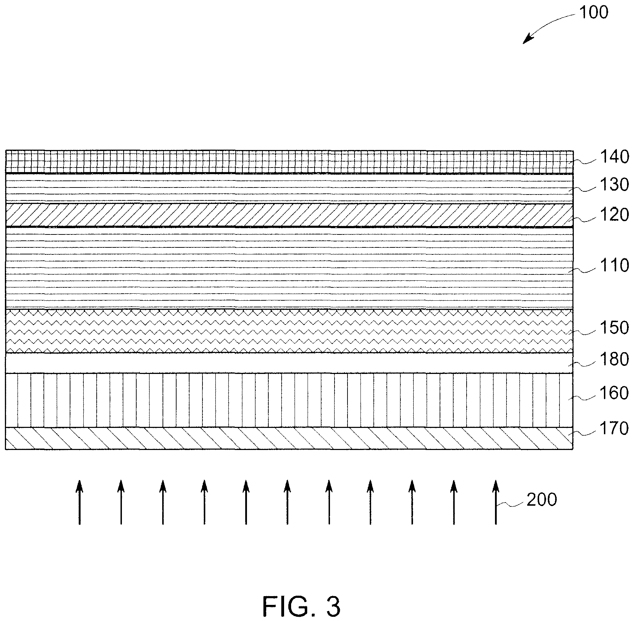

In one embodiment, the photovoltaic device 100 further includes a first electrically conductive layer, also called a back contact layer 140 disposed on the p+-type semiconductor layer 130, as indicated in Fig. 3. In some embodiments, the p+-type semiconductor layer 130 may provide for improved diffusion properties between the first electrically conductive metal layer 140 and the first semiconductor layer 110. Accordingly, in some embodiments, any suitable metal having the desired conductivity and reflectivity may be selected as the back contact layer 140. In one embodiment, the first electrically conductive layer 140 includes gold, platinum, molybdenum, aluminum, chromium, nickel, or silver. In certain embodiments, another metal layer (not shown), for example, aluminum, may be disposed on the first electrically conductive layer 140 to provide lateral conduction to the outside circuit.

In one embodiment, the photovoltaic device 100 further includes a second semiconductor layer 150, wherein the first semiconductor layer 110 is disposed on the second semiconductor layer 150, as indicated in Figures 2 and 3. In some embodiments, the second semiconductor layer includes an n-type material. In some embodiments, the second semiconductor layer 150 may function as a window layer, as indicated in Figures 2 and 3. Namely, the second semiconductor layer or the window layer 150 is the junction-forming layer for the photovoltaic device 100, for the configurations shown in Figures. 2 and 3. The addition of the window layer 150 induces an electric field that produces the photovoltaic effect.

Non-limiting example materials for the second semiconductor layer 150 include cadmium sulfide (CdS), indium (III) sulfide (In₂S₃), zinc sulfide (ZnS), zinc telluride (ZnTe), zinc selenide (ZnSe), cadmium selenide (CdSe), oxygenated cadmium sulfide (CdS:O), copper oxide (Cu₂O), Zn(O,H), and combinations thereof. In a particular embodiment, the second semiconductor layer 150 includes CdS. In one embodiment, the second semiconductor layer 150 has a thickness in a range from about 30 nm to about 150 nm.

In one embodiment, the photovoltaic device 100 further includes a second electrically conductive layer or a front contact layer 160, wherein the second semiconductor layer 150 is disposed on second electrically conductive layer 160, as indicated in Figures 2 and 3. In one embodiment, the second electrically conductive layer 160 includes a transparent conductive oxide (TCO). Non-limiting examples of transparent conductive oxides include cadmium tin oxide (CTO), indium tin oxide (ITO), fluorine-doped tin oxide (SnO:F) or FTO, indium-doped cadmium-oxide, cadmium stannate (Cd₂SnO₄) or CTO, and doped zinc oxide (ZnO), such as aluminum-doped zinc-oxide (ZnO:Al) or AZO, indium-zinc oxide (IZO), and zinc tin oxide (ZnSnOₓ), or combinations thereof. Depending on the specific TCO employed (and on its sheet resistance), the thickness of the second electrically conductive layer 160 may be in a range of from about 50 nm to about 300 nm, in one embodiment.

As indicated in Figures 2 and 3, the second electrically conductive layer 160 is disposed on a support 170. In one embodiment, the support 170 is transparent over the range of wavelengths for which transmission through the support 170 is desired. In one embodiment, the support 170 may be transparent to visible light having a wavelength in a range from about 400 nm to about 1000 nm. In some embodiments, the support 110 includes a material capable of withstanding heat treatment temperatures greater than about 600 °C, such as, for example, silica or borosilicate glass. In some other embodiments, the support 110 includes a material that has a softening temperature lower than 600 °C, such as, for example, soda-lime glass. In some embodiments certain other layers may be disposed between the second electrically conductive layer 160 and the support 170, such as, for example, a reflective layer (not shown).

In certain embodiments, the photovoltaic cell 100, further includes a buffer layer, also called a high resistance transparent conductive oxide (HRT) layer 180, interposed between the second semiconductor layer 150 and the second electrically conductive layer 160, as indicated in Fig. 3. In one embodiment, the thickness of the buffer layer 180 is in a range from about 50 nm to about 100 nm. Non-limiting examples of suitable materials for the buffer layer 180 include tin dioxide (SnO₂), zinc tin oxide (ZTO), zinc-doped tin oxide (SnO₂:Zn), zinc oxide (ZnO), indium oxide (In₂O₃), or combinations thereof.

In one embodiment, a photovoltaic device 100 is provided, as indicated in Figure 2. The photovoltaic device 100 includes a support 170 and a second electrically conductive layer 160 disposed on the support 170. The photovoltaic device 100 further includes an n-type semiconductor layer 150 disposed on the second electrically conductive layer 160 and a substantially intrinsic semiconductor layer 110 disposed on the n-type semiconductor layer 150. The photovoltaic device 100 further includes a p+-type semiconductor layer 130 disposed on the substantially intrinsic semiconductor layer 110 and a first electrically conductive layer 140 disposed on the p+-type semiconductor layer 130. An interlayer 120 is interposed between the p+-type semiconductor layer 130 and the substantially intrinsic semiconductor layer 110, wherein the interlayer 120 includes magnesium and tellurium.

In some embodiments, a method of making a photovoltaic device is provided. Referring to Figures 2 and 3, in some embodiments, the method includes disposing a first electrically conductive layer 160 on a support 170 by any suitable technique, such as sputtering, chemical vapor deposition, spin coating, spray coating, or dip coating. Referring to FIG. 3, in some embodiments, an optional buffer layer 180 may be deposited on the second electrically conductive layer 160 using sputtering, followed by deposition of the second electrically conductive layer 160 on the buffer layer 180. The n-type second semiconductor layer or window layer 150 may be then deposited on the second electrically conductive layer 160. Non-limiting examples of the deposition methods for the n-type semiconductor layer 150 include one or more of close-space sublimation (CSS), vapor transport method (VTM), sputtering, and electrochemical bath deposition (CBD).

In some embodiments, the method further includes disposing a first semiconductor layer (absorber layer) 110 on the second semiconductor layer 150. In one embodiment, the first semiconductor layer 110 may be deposited by employing one or more methods selected from close-space sublimation (CSS), vapor transport method (VTM), ion-assisted physical vapor deposition (IAPVD), radio frequency or pulsed magnetron sputtering (RFS or PMS), plasma enhanced chemical vapor deposition (PECVD), and electrochemical deposition (ECD). In one embodiment, the second semiconductor layer may be deposited to be a p-type or i-type semiconductor layer by varying one or more of the dopants, the thickness of the deposited layer, and post-deposition processing.

In one embodiment, when the first semiconductor layer 110 is a p-type cadmium telluride layer, the first semiconductor layer 110 may be treated with cadmium chloride. In one embodiment, first semiconductor layer 110 may be treated with a solution of CdCl₂ salt. In another embodiment, first semiconductor layer 110 may be treated with CdCl₂ vapor. The treatment with CdCl₂ is known to increase the carrier density of the first semiconductor layer 110. The treatment with cadmium chloride may be followed by an etching or rinsing step. In one embodiment, the etch may be carried out by using acid. In other embodiments the CdCl₂ may be rinsed off the surface, resulting in a stoichiometric cadmium telluride at the interface, mainly removing the cadmium oxide and CdCl₂ residue from the surface, leaving a cadmium-to-tellurium ratio of about 1 at the surface. The etching works by removing non-stoichiometric material that forms at the surface during processing. Other etching techniques known in the art that may result in a stoichiometric cadmium telluride at the interface may also be employed. An interlayer 120 including a composition of magnesium and tellurium is then deposited on the first semiconductor layer using one or more of the following techniques: sputtering, molecular beam epitaxy (MBE), evaporation, chemical bath deposition (CBD), metal-organic chemical vapor deposition (MOCVD), and atomic layer epitaxy (ALE). A p+-type semiconductor layer 130 is then deposited over the interlayer 120. The deposition of the p+-type layer 130 may be achieved by depositing a p-type material using any suitable technique, for example PECVD. Finally, the device may be completed by depositing an electrically conductive layer or a back contact layer 140, for example a metal layer.

In one embodiment, a solar panel, i.e., a photovoltaic module comprising a plurality of photovoltaic devices as described above may be assembled in series to form a photovoltaic module.

The appended claims are intended to claim the invention as broadly as it has been conceived and the examples herein presented are illustrative of selected embodiments from a manifold of all possible embodiments. Accordingly, it is the Applicants' intention that the appended claims are not to be limited by the choice of examples utilized to illustrate features of the present invention. As used in the claims, the word "comprises" and its grammatical variants logically also subtend and include phrases of varying and differing extent such as for example, but not limited thereto, "consisting essentially of" and "consisting of." Where necessary, ranges have been supplied; those ranges are inclusive of all sub-ranges there between. It is to be expected that variations in these ranges will suggest themselves to a practitioner having ordinary skill in the art and where not already dedicated to the public, those variations should where possible be construed to be covered by the appended claims. It is also anticipated that advances in science and technology will make equivalents and substitutions possible that are not now contemplated by reason of the imprecision of language and these variations should also be construed where possible to be covered by the appended claims.

Various aspects and embodiments of the present invention are defined by the following numbered clauses:
1. A photovoltaic device, comprising:
   a first semiconductor layer;
   a p+-type semiconductor layer; and
   an interlayer interposed between the first semiconductor layer and the p+-type semiconductor layer, wherein the interlayer comprises magnesium and tellurium.
2. The photovoltaic device of clause 1, wherein the interlayer comprises a composition having a formula (I):

   (I) MgₓCd₁₋ₓTe;

   wherein "x" is in a range from about 0.05 to about 0.6.
3. The photovoltaic device of clause 2, wherein "x" is in a range from about 0.1 to about 0.3.
4. The photovoltaic device of clause 1, wherein a percentage difference between a lattice constant of the first semiconductor layer and a lattice constant of the interlayer is less than about 1%.
5. The photovoltaic device of clause 1, wherein the interlayer has a band gap in a range from about 1.5 eV to about 3.5 eV.
6. The photovoltaic device of clause 1, wherein the interlayer has a band gap in a range from about 1.5 eV to about 2.5 eV.
7. The photovoltaic device of clause 1, wherein the interlayer comprises a p-doped magnesium telluride or a p-doped magnesium cadmium telluride.
8. The photovoltaic device of clause 1, wherein the first semiconductor layer comprises a p-type material.
9. The photovoltaic device of clause 1, wherein the first semiconductor layer comprises a substantially intrinsic material.
10. The photovoltaic device of clause 1, wherein the first semiconductor layer comprises a material selected from a group consisting of cadmium telluride, cadmium zinc telluride, cadmium sulfur telluride, cadmium manganese telluride, cadmium magnesium telluride, and combinations thereof.
11. The photovoltaic device of clause 1, wherein the first semiconductor layer has a band gap in a range from about 1.3 eV to about 1.6 eV.
12. The photovoltaic device of clause 1, wherein the p+-type semiconductor layer comprises a p-type material selected from a group consisting of amorphous Si:H, amorphous SiC:H, crystalline Si, microcrystalline Si:H, microcrystalline SiGe:H, amorphous SiGe:H, amorphous Ge, microcrystalline Ge, GaAs, BaCuSF, BaCuSeF, BaCuTeF, LaCuOS, LaCuOSe, LaCuOTe, (LaSr)CuOS, LaCuOSe_{0.6}Te_{0.4}, BiCuOSe, (BiCa)CuOSe, PrCuOSe, NdCuOS, Sr₂Cu₂ZnO₂S₂, Sr₂CuGaO₃S, and combinations thereof.
13. The photovoltaic device of clause 1, wherein the p+-type semiconductor layer comprises a p+ doped material selected from a group consisting of zinc telluride, magnesium telluride, manganese telluride, beryllium telluride, mercury telluride, arsenic telluride, antimony telluride, copper telluride, and combinations thereof.
14. The photovoltaic device of clause 13, wherein the p+ doped material further comprises a dopant selected from a group consisting of copper, gold, nitrogen, phosphorus, antimony, arsenic, silver, bismuth, sulfur, sodium, and combinations thereof.
15. The photovoltaic device of clause 1, wherein the p+-type semiconductor layer has a carrier density in a range from about 10¹⁷ per cubic centimeter to about 10²⁰ per cubic centimeter.
16. The photovoltaic device of clause 1, wherein the first semiconductor layer has a thickness in a range from about 1 micron to about 3 microns.
17. The photovoltaic device of clause 1, wherein the p+-type semiconductor layer has a thickness in a range from about 50 nm to about 200 nm.
18. The photovoltaic device of clause 1, wherein the interlayer has a thickness in a range from about 10 nm to about 100 nm.
19. The photovoltaic device of clause 1, further comprising a first electrically conductive layer disposed on the p+-type semiconductor layer.
20. The photovoltaic device of clause 19, wherein the first electrically conductive layer comprises gold, platinum, molybdenum, aluminum, chromium, nickel, or silver.
21. The photovoltaic device of clause 1, further comprising a second semiconductor layer, wherein the first semiconductor layer is disposed on the second semiconductor layer.
22. The photovoltaic device of clause 21, wherein the second semiconductor layer comprises an n-type material.
23. The photovoltaic device of clause 21, wherein the second semiconductor layer comprises cadmium sulfide, cadmium selenide, oxygenated cadmium sulfide, zinc telluride, zinc selenide, zinc sulfide, indium selenide, indium sulfide, zinc oxihydrate, or combinations thereof.
24. The photovoltaic device of clause 21, further comprising a second electrically conductive material, wherein the second semiconductor layer is disposed on the second electrically conductive layer.
25. The photovoltaic device of clause 24, wherein the second electrically conductive layer comprises cadmium tin oxide, indium tin oxide, zinc tin oxide, fluorine-doped tin oxide, indium-doped cadmium oxide, aluminum-doped zinc oxide, indium zinc oxide, or combinations thereof.
26. A photovoltaic device, comprising:
   a support;
   a second electrically conductive layer disposed on the support;
   an n-type semiconductor layer disposed on the second electrically conductive layer;
   a substantially intrinsic semiconductor layer disposed on the n-type semiconductor layer;
   a p+-type semiconductor layer disposed on the substantially intrinsic semiconductor layer;
   a first electrically conductive layer disposed on the p+-type semiconductor layer; and
   an interlayer interposed between the p+-type semiconductor layer and the substantially intrinsic semiconductor layer, wherein the interlayer comprises magnesium and tellurium.
27. A photovoltaic module comprising a plurality of photovoltaic devices as defined in clause 26.

## Claims

1. A photovoltaic device, comprising:
a first semiconductor layer;
a p+-type semiconductor layer; and
an interlayer interposed between the first semiconductor layer and the p+-type semiconductor layer, wherein the interlayer comprises magnesium and tellurium.

2. The photovoltaic device of claim 1, wherein the interlayer comprises a composition having a formula (I):
(II) MgₓCd₁₋ₓTe;
wherein "x" is in a range from about 0.05 to about 0.6.

3. The photovoltaic device of claim 1 or claim 2, wherein a percentage difference between a lattice constant of the first semiconductor layer and a lattice constant of the interlayer is less than about 1%.

4. The photovoltaic device of any preceding claim, wherein the interlayer has a band gap in a range from about 1.5 eV to about 3.5 eV.

5. The photovoltaic device of any preceding claim, wherein the interlayer comprises a p-doped magnesium telluride or a p-doped magnesium cadmium telluride.

6. The photovoltaic device of any preceding claim, wherein the first semiconductor layer comprises a p-type material.

7. The photovoltaic device of any preceding claim, wherein the first semiconductor layer comprises a substantially intrinsic material.

8. The photovoltaic device of any preceding claim, wherein the first semiconductor layer comprises a material selected from a group consisting of cadmium telluride, cadmium zinc telluride, cadmium sulfur telluride, cadmium manganese telluride, cadmium magnesium telluride, and combinations thereof.

9. The photovoltaic device of any preceding claim, wherein the first semiconductor layer has a band gap in a range from about 1.3 eV to about 1.6 eV.

10. The photovoltaic device of any preceding claim, wherein the p+-type semiconductor layer comprises a p-type material selected from a group consisting of amorphous Si:H, amorphous SiC:H, crystalline Si, microcrystalline Si:H, microcrystalline SiGe:H, amorphous SiGe:H, amorphous Ge, microcrystalline Ge, GaAs, BaCuSF, BaCuSeF, BaCuTeF, LaCuOS, LaCuOSe, LaCuOTe, (LaSr)CuOS, LaCuOSe_{0.6}Te_{0.4}, BiCuOSe, (BiCa)CuOSe, PrCuOSe, NdCuOS, Sr₂Cu₂ZnO₂S₂, Sr₂CuGaO₃S, and combinations thereof.

11. The photovoltaic device of any preceding claim, wherein the p+-type semiconductor layer comprises a p+ doped material selected from a group consisting of zinc telluride, magnesium telluride, manganese telluride, beryllium telluride, mercury telluride, arsenic telluride, antimony telluride, copper telluride, and combinations thereof.

12. The photovoltaic device of claim 11, wherein the p+ doped material further comprises a dopant selected from a group consisting of copper, gold, nitrogen, phosphorus, antimony, arsenic, silver, bismuth, sulfur, sodium, and combinations thereof.

13. The photovoltaic device of any preceding claim, further comprising a first electrically conductive layer disposed on the p+-type semiconductor layer.

14. The photovoltaic device of any preceding claim, further comprising a second semiconductor layer, wherein the first semiconductor layer is disposed on the second semiconductor layer.

15. A photovoltaic module comprising a plurality of photovoltaic devices as defined in any preceding claim.
